Europäisches Patentamt

European Patent Office

Office européen des brevets

(11) Veröffentlichungsnummer: **0 359 852**
**A1**

# EUROPÄISCHE PATENTANMELDUNG

(21) Anmeldenummer: 88115488.4

(22) Anmeldetag: 21.09.88

(51) Int. Cl.⁵: **H01L 21/265 , H01L 21/22**

Die Bezeichnung der Erfindung wurde geändert (Richtlinien für die Prüfung im EPA, A-III, 7.3).

(43) Veröffentlichungstag der Anmeldung:
**28.03.90 Patentblatt 90/13**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Orlowski, Marius, Dr.rer.nat.**
**Zweibrückenstrasse 19**
**D-8000 München 2(DE)**

(54) **Verfahren zur Herstellung von flachen dotierten Bereichen mit niedrigem Schichtwiderstand in einem Siliziumsubstrat.**

(57) In dem Verfahren wird die Erkenntnis ausgenutzt, daß bestimmte Dotierstoffe, z.B. Gallium und Bor, sich als Zwischengitteratome in Siliziumkristallen gegenseitig anziehen. Es werden in ein mit einer $SiO_2$-Schicht (2) versehenes Siliziumsubstrat (1) nacheinander eine erste Dotierstoffart, z.B. Gallium, und eine zweite Dotierstoffart, z.B. Bor, implantiert. Anschließend wird das Siliziumsubstrat (1) mit der $SiO_2$-Schicht (2) und den Implantationsgebieten (31,4) einer Wärmebehandlung unterzogen. Das Verfahren findet Anwendung in der Herstellung flacher Source/Drain-Gebiete mit niedrigem Schichtwiderstand für MOSFET.

EP 0 359 852 A1

FIG 3

# Verfahren zur Herstellung von flachen dotierten Bereichen mit niedrigem Schichtwiderstand in einem Siliziumsubstrat, insbesondere zur Herstellung von flachen Source/Drain Gebieten

Die Erfindung betrifft ein Verfahren zur Herstellung von flachen dotierten Bereichen mit niedrigem Schichtwiderstand in einem Siliziumsubstrat.

Eine Verringerung der Strukturgrößen von integrierten Schaltungen erfordert die Herstellung von flachen dotierten Bereichen. Insbesondere bei einer Verkleinerung von integrierten MOS-Schaltungen ist eine Verminderung der Eindringtiefe der Dotierstoffe in den Source/Drain-Gebieten erforderlich. Dadurch bedingt erhöht sich der Serienwiderstand dieser Gebiete erheblich.

Eine Möglichkeit, den zu hohen Serienwiderstand von implantierten Source/Drain-Gebieten zu reduzieren, ist die selbstjustierende Silizidierung dieser Gebiete mit Platin Silizid, wie sie in einem Aufsatz von Shibata et al im IEEE, ED 29 (1982) auf den Seiten 531 bis 535 beschrieben ist. Ein weiteres Verfahren zur Herstellung von MOS Feldeffekttransistorstrukturen mit extrem flachen Source/Drain Zonen ist aus der europäischen Patentanmeldung EP 0 268 941 A1 bekannt. Zwischen der Gateelektrode und den Feldeffektbereichen werden durch selektive Epitaxie einkristalline, dotierte Siliziumgebiete erzeugt, die als Diffusionsquelle für die Erzeugung der Source/Drain-Zonen im Substrat dienen.

Eine weitere Schwierigkeit in der Herstellung von flachen dotierten Bereichen besteht in der Dotierstoffkonzentrationsverteilung über die Tiefe des Bereichs. Es ist bekannt, im Siliziumsubstrat eine Voramorphisierung mit einer Silizium- oder Germanium-Implantation vorzunehmen. Nachfolgend erfolgt die Bor-Implantation.

Der Erfindung liegt die Aufgabe zugrunde, ein weiteres Verfahren zur Herstellung eines flachen dotierten Bereiches mit niedrigem Schichtwiderstand anzugeben, bei dem eine definierte und reproduzierbare Dotierstoffkonzentrationsverteilung über die Tiefe des Bereichs gegeben ist.

Diese Aufgabe wird erfindungsgemäß gelöst durch ein Verfahren der eingangs genannten Art mit folgenden Schritten:

    a) auf dem Siliziumsubstrat wird eine $SiO_2$-Schicht erzeugt,

    b) durch die $SiO_2$-Schicht wird ein erster Dotierstoff in das Siliziumsubstrat implantiert,

    c) durch die $SiO_2$-Schicht wird ein zweiter Dotierstoff in das Siliziumsubstrat implantiert, wobei der zweite Dotierstoff so gewählt wird, daß der erste Dotierstoff und der zweite Dotierstoff die Eigenschaft haben, sich als Zwischengitteratome im Siliziumsubstrat gegenseitig anzuziehen,

    d) das Siliziumsubstrat mit der $SiO_2$-Schicht wird einem thermischen Aktivierungsschritt unterzogen.

Die Erfindung macht sich die Erkenntnis zunutze, daß zwischen verschiedenen Dotierstoffen in einem Substrat eine Wechselwirkung besteht (s. z.B. S. Aronowitz, J.Appl. Phys. 61 (7) Seite 2495 ff (1987)). Diese Wechselwirkung zwischen verschiedenen Dotierstoffen führt insbesondere in Strukturen mit kleinen Geometrien zu einer gegenseitigen Beeinflussung der Diffusion im Kristall. Diese Beeinflussung kann in einer Verstärkung oder einer Unterdrückung bestehen. Theoretisch wird eine attraktive Wechselwirkung zwischen Atomen vorhergesagt, die als Dotierstoff im Silizium zur p-Leitung führen. Dieser Effekt wurde experimentell insbesondere für die Dotierstoffkombinationen Aluminium und Bor, Aluminium und Gallium sowie Bor und Gallium bestätigt. Es hat sich gezeigt, daß die Anziehung zwischen Bor und Gallium besonders groß ist.

Mit der attraktiven Wechselwirkung zwischen den verschiedenen Dotierstoffen geht eine gegenseitige Retardierung ihrer Diffusion sowie eine Zunahme ihrer elektrischen Aktivierung einher. Durch Implantation zweier Dotierstoffarten, die sich als Zwischengitteratome gegenseitig anziehen, ist es daher möglich, flachere dotierte Bereiche mit gleichzeitig erniedrigtem Schichtwiderstand herzustellen.

Bei Anwesenheit von Gallium kann der sog. Channeling Effekt bei einer nachfolgenden Borimplantation vermieden werden. Die- ser Effekt stellt eine Grenze für die Borimplantation dar. Daher können durch zwei Implantationsschritte mit Gallium und Bor flachere Bor-dotierte Bereiche erzielt werden. Besonders günstig ist es, dabei die Galliumdosis höher als $5 * 10^{14}$ cm$^{-2}$ zu wählen, da dieses die kritische Amorphisierungsdosis ist.

Weitere Ausgestaltungen der Erfindung gehen aus den übrigen Ansprüchen hervor.

Das erfindungsgemäße Verfahren ist insbesondere geeignet, bei der Herstellung von P-Kanal-MOSFETs zur Erzeugung von flachen Source/Drain-Gebieten mit niedrigem Schichtwiderstand eingesetzt zu werden.

Im folgenden wird die Erfindung anhand eines Ausführungsbeispiels und der Figuren näher erläutert.

FIG 1 zeigt ein Siliziumsubstrat nach dem Aufbringen einer $SiO_2$-Schicht.

FIG 2 zeigt das Siliziumsubstrat nach dem ersten Implantationsschritt.

FIG 3 zeigt das Siliziumsubstrat nach dem zweiten Implantationsschritt.

FIG 4 zeigt das Siliziumsubstrat nach der thermischen Aktivierung.

In allen Figuren haben gleiche Bezugzeichen die gleiche Bedeutung.

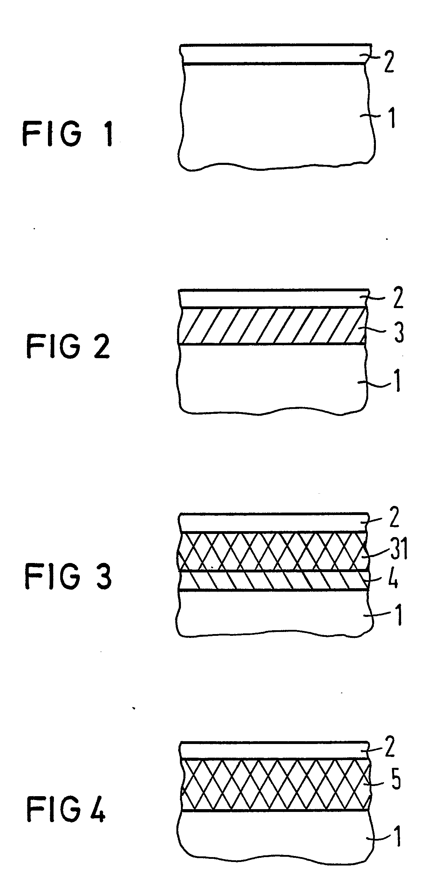

In FIG 1 ist ein Siliziumsubstrat 1 dargestellt. Auf das Siliziumsubstrat 1 wird eine $SiO_2$-Schicht 2 aufgebracht. Die $SiO_2$-Schicht 2 hat eine Dicke von maximal 20 nm. Sie dient als Streuoxid für die nachfolgenden Implantationsschritte.

In FIG 2 ist das Siliziumsubstrat 1 mit der $SiO_2$-Schicht 2 nach einem ersten Implantationsschritt dargestellt. Durch den ersten Implantationsschritt wird ein erstes Implantationsgebiet 3 erzeugt. Der erste Implantationsschritt erfolgt mit einem ersten Dotierstoff, z.B. mit Gallium, wobei die Dosis $2 * 10^{14}$ bis $2 * 10^{15} cm^{-2}$ und die Energie 100 bis 250 keV beträgt.

In FIG3 ist das Siliziumsubstrat 1 mit der $SiO_2$-Schicht 2 nach einem zweiten Implantationsschritt dargestellt. Der zweite Implantationsschritt erfolgt mit einem zweiten Dotierstoff, z.B. mit Bor mit einer Dosis von etwa $5 * 10^{15} cm^{-2}$ und einer Energie von 25 bis 60 keV. Der zweite Implantationsschritt kann auch aus einer Implantation von Borfluorid (BF und/oder $BF_2$) bestehen. Durch den zweiten Implantationsschritt wird aus dem ersten Implantationsgebiet 3 ein verändertes erstes Implantationsgebiet 31. Das veränderte erste Implantationsgebiet 31 enthält sowohl den ersten Dotierstoff als auch den zweiten Dotierstoff. Da der zweite Dotierstoff im zweiten Implantationsschritt tiefer in das Siliziumsubstrat 1 eindringt als der erste Dotierstoff im ersten Implantationsschritt, wird im zweiten Implantationsschritt ein zweites Implantationsgebiet 4 gebildet. Das zweite Implantationsgebiet 4 liegt unterhalb des veränderten ersten Implantationsgebietes 31 im Siliziumsubstrat 1. Das zweite Implantationsgebiet 4 enthält nur den zweiten Dotierstoff.

In einem thermischen Aktivierungsschritt wird die Diffusion der ersten Dotierstoffart und der zweiten Dotierstoffart angeregt. Der thermische Aktivierungsprozeß besteht z.B. in einem konventionellen Ofenprozeß bei etwa 800 bis 900°C oder in einem Rapid Thermal-Anneal Prozeß, d.h. durch schnelles Aufheizen.

In FIG4 ist das Siliziumsubstrat 1 mit der $SiO_2$-Schicht 2 nach der thermischen Aktivierung dargestellt. Da sich die erste Dotierstoffart, z.B. Gallium, und die zweite Dotierstoffart, z.B. Bor, gegenseitig in ihrer Diffusion beeinflussen, wie oben erläutert, kommt es infolge der thermischen Aktivierung zur Bildung eines gesamten dotierten Gebietes 5. Das gesamte dotierte Gebiet 5 ist mit beiden Dotierstoffarten versehen, da sich diese bei der Diffusion gegenseitig anziehen. Die Zunahme der elektrischen Aktivierung ist daher maximal.

Bei der thermischen Aktivierung kommt es zu einer Diffusion des ersten Dotierstoffes, der zuvor nur im Bereich des veränderten ersten Implantationsgebietes 31 vorhanden war, in das zweite Implantationsgebiet 4. Da zwischen dem ersten Dotierstoff und dem zweiten Dotierstoff eine attraktive Wechselwirkung besteht, diffundiert der zweite Dotierstoff, der vor der thermischen Aktivierung im Bereich des zweiten Implantationsgebietes 4 vorhanden war, in Richtung des veränderten ersten Implantationsgebietes 31, in dem der erste Dotierstoff vorhanden ist. Nach der thermischen Aktivierung ist daher die räumliche Verteilung der Dotierstoffe so, daß das gesamte dotierte Gebiet 5 tiefer in das Siliziumsubstrat 1 hineinreicht als das veränderte erste Implantationsgebiet 31, jedoch nicht so tief wie das zweite Implantationsgebiet 4.

Bei der Verwendung des erfindungsgemäßen Verfahrens zur Herstellung von flachen Source/Drain-Gebieten ist es wichtig, daß durch die zusätzliche Implantation die sog. Junctiontiefe nicht vergrößert wird. In dem angegebenen Beispiel ist dies sichergestellt, da der Diffusionskoeffizient von Gallium nur geringfügig größer ist als derjenige von Bor.

## Ansprüche

1. Verfahren zur Herstellung von flachen dotierten Bereichen mit niedrigem Schichtwiderstand in einem Siliziumsubstrat mit folgenden Schritten:

a) auf dem Siliziumsubstrat (1) wird eine $SiO_2$-Schicht (2) erzeugt,

b) durch die $SiO_2$-Schicht (2) wird ein erster Dotierstoff in das Siliziumsubstrat (1) implantiert,

c) durch die $SiO_2$-Schicht (2) wird ein zweiter Dotierstoff in das Siliziumsubstrat (1) implantiert, wobei der zweite Dotierstoff so ausgewählt wird, daß der ersten Dotierstoff und der zweite Dotierstoff die Eigenschaft haben, sich als Zwischengitteratome im Siliziumsubstrat (1) gegenseitig anzuziehen,

d) das Siliziumsubstrat (1) mit der $SiO_2$-Schicht (2) und den Implantationsgebieten (3, 4) wird einem thermischen Aktivierungsschritt unterzogen.

2. Verfahren nach Anspruch 1, dadurch **gekennzeichnet,** daß als erster Dotierstoff und als zweiter Dotierstoff je eines der Elemente Aluminium, Bor und Gallium verwendet wird.

3. Verfahren nach Anspruch 1 oder 2 **gekennzeichnet** durch folgende Schritte:

a) durch die $SiO_2$-Schicht (2) erfolgt eine erste Implantation von Gallium mit einer Dosis von etwa $2 * 10^{14} - 2 * 10^{15} cm^{-2}$ und einer Energie von etwa 100 bis 250 keV,

b) es folgt eine Implantation mit Bor durch die $SiO_2$-Schicht (2) mit einer Dosis von etwa $5 * 10^{15} cm^{-2}$ und einer Energie von etwa 25 bis 60 keV,

c) das Siliziumsubstrat (1) mit der SiO$_2$-Schicht (2) und den Implantationsgebieten (3,4) wird in einem Ofen bei etwa 800 bis 900°C ausgeheilt.

4. Verwendung des Verfahrens nach einem der Ansprüche 1 bis 3 bei der Herstellung von P-Kanal-MOSFETs zur Erzeugung von flachen Source/Drain-Gebieten mit niedrigem Schichtwiderstand.

FIG 1

FIG 2

FIG 3

FIG 4

Europäisches Patentamt

EUROPÄISCHER RECHERCHENBERICHT

Nummer der Anmeldung

EP 88 11 5488

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,X | JOURNAL OF APPLIED PHYSICS, Band 61, Nr. 7, 1. April 1987, Seiten 2495-2500, American Institute of Physics, Woodbury, New York, US; S. ARONOWITZ: "Interstitial interactions: Aluminum-boron, aluminum-gallium, and boron-gallium pull effect" * Seite 2496, Tabelle I, Punkte VI und VIII; Seiten 2498-2500 * | 1,2 | H 01 L 21/265 H 01 L 21/22 |
| A | Idem | 3,4 | |
| X | EP-A-0 258 148 (FAIRCHILD SEMICONDUCTOR CORP.) * Seite 2, Zeile 55 - Seite 5, Zeile 38; Figuren 1-4 * | 1,2,4 | |
| A | | 3 | |
| A | IBM TECHNICAL DISCLOSURE BULLETIN, Band 22, Nr. 10, März 1980, Seite 4601, New York, US; A. SCHMITT et al.: "Method of eliminating lattice defects in ion implantation" * Der ganze Artikel * | 1-3 | RECHERCHIERTE SACHGEBIETE (Int. Cl.4) |
| A | SOVIET PHYSICS DOKLADY, Band 251, Nr. 4-6, April 1980, Seiten 305-306, American Insitute of Physics, New York, US; V.S. VAVILOV et al.: "Joint implantation of gallium and boron ions in silicon" * Der ganze Artikel * -/- | 1-3 | H 01 L |

Der vorliegende Recherchenbericht wurde für alle Patentansprüche erstellt

| Recherchenort | Abschlußdatum der Recherche | Prüfer |
|---|---|---|
| DEN HAAG | 25-05-1989 | GELEBART J.F.M. |

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | APPLIED PHYSICS LETTERS, Band 51, Nr. 24, 14. Dezember 1987, Seiten 2037-2039, American Insitute of Physics, New York, NY, US; J. MATSUO et al.: "Abnormal solid solution and activation behavior in Ga-implanted Si(100)" --- | | |
| A | EXTENDED ABSTRACTS, Band 82-2, Oktober 1982, Seite 278, Zusammenfassung Nr. 177, Pennington, New Jersey, US; C.M. OSBURN et al.: "Edge breakdown of poly-Si gates over thin oxides during ion implantation" ----- | | |

RECHERCHIERTE
SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 25-05-1989 | GELEBART J.F.M. |